(19) Europäisches Patentamt
European Patent Office
Office européen des brevets

(11) **EP 4 693 593 A1**

(12) **EUROPEAN PATENT APPLICATION**
published in accordance with Art. 153(4) EPC

(43) Date of publication:
**11.02.2026 Bulletin 2026/07**

(21) Application number: **24778724.5**

(22) Date of filing: **08.02.2024**

(51) International Patent Classification (IPC):
*H01M 10/42* (2006.01)     *G01R 31/378* (2019.01)
*G01R 31/392* (2019.01)     *H01M 10/48* (2006.01)
*H02J 7/00* (2026.01)

(52) Cooperative Patent Classification (CPC):
**G01R 31/378; G01R 31/392; H01M 10/42;
H01M 10/48; H02J 7/00;** Y02E 60/10

(86) International application number:
**PCT/JP2024/004386**

(87) International publication number:
**WO 2024/202579 (03.10.2024 Gazette 2024/40)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **24.03.2023 JP 2023048878**

(71) Applicant: **Panasonic Intellectual Property
Management Co., Ltd.
Kadoma-shi, Osaka 571-0057 (JP)**

(72) Inventors:
• **YANG Changhui**
  **Kadoma-shi, Osaka 571-0057 (JP)**
• **MATSUDA Takashi**
  **Kadoma-shi, Osaka 571-0057 (JP)**
• **SADA Tomokazu**
  **Kadoma-shi, Osaka 571-0057 (JP)**

(74) Representative: **Novagraaf International SA
Chemin de l'Echo 3
1213 Onex, Geneva (CH)**

(54) **BATTERY ANALYSIS SYSTEM, BATTERY ANALYSIS METHOD, BATTERY ANALYSIS PROGRAM, AND STORAGE MEDIUM HAVING BATTERY ANALYSIS PROGRAM RECORDED THEREON**

(57)    A data acquisition unit acquires use history data of a secondary battery and battery information for identifying a type of the secondary battery. A deterioration characteristic search unit searches a deterioration characteristic database based on the battery information to identify deterioration characteristic information including a storage deterioration characteristic, a charge deterioration characteristic, and a discharge deterioration characteristic of the secondary battery. An internal deterioration state analysis unit estimates a storage deterioration amount, a charge deterioration amount, and a discharge deterioration amount of the secondary battery based on the deterioration characteristic information identified by the deterioration characteristic search unit and the use history data acquired by the data acquisition unit. A reuse determination unit determines a secondary use destination after an end of primary use of the secondary battery based on a breakdown of the storage deterioration amount, the charge deterioration amount, and the discharge deterioration amount of the second battery.

EP 4 693 593 A1

# FIG. 3

BATTERY ANALYSIS SYSTEM

Description

## TECHNICAL FIELD

The present disclosure relates to a battery analysis system, a battery analysis method, and a battery analysis program for analyzing an internal state of a secondary battery, and a recording medium.

## BACKGROUND ART

Some secondary batteries end primary use in accordance with a predetermined standard, and are used for secondary use. The end time of the primary use and the secondary use destination of the secondary battery are generally determined based on a simple deterioration evaluation based on external conditions. For example, in an in-vehicle battery mounted on an EV, the end time of the primary use is often determined by an elapsed time or an accumulated running distance from the manufacture of the vehicle. For example, it is determined that the primary use is ended when five years have elapsed or when the running distance reaches 200,000 km from the manufacture.

PTL 1 discloses a method for recognizing a deterioration state of a secondary battery from external conditions such as current, voltage, and temperature, and for determining an application in accordance with the deterioration state.

Citation List

Patent Literature

PTL 1: International Publication No. WO 21/152826

## SUMMARY OF THE INVENTION

Technical problem

In the secondary battery, even in the same external deterioration state (SOH: State Of Health), the internal deterioration state (storage deterioration, charge deterioration, discharge deterioration) may be different depending on the usage. Even if the deterioration does not progress, an abnormality such as a micro-short circuit may occur inside the battery, leading to a risk in continuous use. The determination of the secondary use destination of the secondary battery described above is not made based on a sufficient consideration of the internal state of the battery, and cannot be said to be an optimal determination.

The present disclosure has been made in view of such a situation, and an object thereof is to provide a technique for determining an appropriate secondary use destination of a secondary battery.

Solution to problem

In order to solve the above problem, a battery analysis system according to an aspect of the present disclosure includes: a data acquisition unit configured to acquire use history data of a secondary battery and battery information for identifying a type of the secondary battery; a deterioration characteristic search unit configured to search a deterioration characteristic database based on the battery information to identify deterioration characteristic information including a storage deterioration characteristic, a charge deterioration characteristic, and a discharge deterioration characteristic of the secondary battery; an internal deterioration state analysis unit configured to estimate a storage deterioration amount, a charge deterioration amount, and a discharge deterioration amount of the secondary battery based on the deterioration characteristic information identified by the deterioration characteristic search unit and the use history data acquired by the data acquisition unit; and a reuse determination unit configured to determine a secondary use destination after an end of primary use of the secondary battery based on the breakdown of the storage deterioration amount, the charge deterioration amount, and a discharge deterioration amount each estimated by the internal deterioration state analysis unit.

Any combinations of configuration elements described above and expressions of the present disclosure that are converted in terms of apparatuses, systems, methods, computer programs, recording media, and the like are also effective as aspects of the present disclosure.

Advantageous effect of invention

The present disclosure makes it possible to determine an appropriate secondary use destination of the secondary battery.

## BRIEF DESCRIPTION OF THE DRAWINGS

Fig. 1 is a diagram illustrating a schematic configuration of an electric vehicle according to an exemplary embodiment.
Fig. 2 is a diagram for describing a battery analysis system according to an exemplary embodiment.
Fig. 3 is a diagram illustrating a configuration example of the battery analysis system according to the exemplary embodiment.
Fig. 4 is a diagram illustrating an example of a storage deterioration characteristic map.
Fig. 5A is a diagram illustrating an example of a charge and discharge deterioration characteristic map.
Fig. 5B is a diagram illustrating an example of a charge and discharge deterioration characteristic map.
Fig. 6 is a flowchart for describing an example of a search method for a deterioration characteristic.
Fig. 7 is a flowchart for describing estimation processing of an SOH according to the exemplary embodiment.
Fig. 8 is a flowchart illustrating a subroutine for describing processing of estimating a storage deterioration increase amount.
Fig. 9 is a flowchart illustrating a subroutine for describing processing of estimating a charge deterioration increase amount.
Fig. 10 is a flowchart illustrating a subroutine for describing processing of estimating a discharge deterioration increase amount.
Fig. 11 is a diagram comparing an SOH of a cell simulated by an internal deterioration state estimation method according to the exemplary embodiment with a time transition of the SOH of the cell based on an actual measurement result.
Fig. 12 is a diagram illustrating an example of an analysis result of a breakdown of a storage deterioration amount, a charge deterioration amount, and a discharge deterioration amount.
Fig. 13 is a flowchart illustrating an overall flow of a reuse determination processing for a battery pack according to the exemplary embodiment.
Fig. 14 is a flowchart for describing a specific example of processing of determining an end time of a primary use.
Fig. 15 is a flowchart for describing Specific Example 1 of processing of determining a secondary use destination.
Fig. 16 is a flowchart for describing Specific Example 2 of processing of determining a secondary use destination.

## DESCRIPTION OF EMBODIMENT

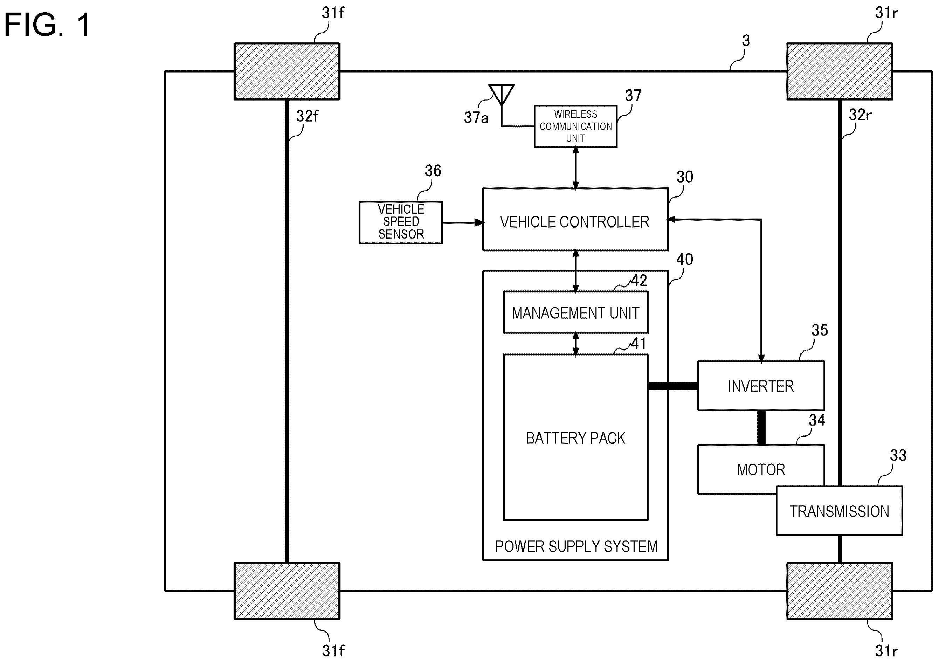

Fig. 1 is a diagram illustrating a schematic configuration of electric vehicle 3 according to the exemplary embodiment. In the present exemplary embodiment, a pure EV on which an internal-combustion engine is not mounted is assumed as electric vehicle 3. Electric vehicle 3 illustrated in Fig. 1 is a rear-wheel drive (2WD) EV including a pair of front wheels 31f, a pair of rear wheels 31r, and motor 34 serving as a power supply. The pair of front wheels 31f is coupled by front wheel axle 32f, and the pair of rear wheels 31r is coupled by rear wheel axle 32r. Transmission 33 transmits rotation of motor 34 to rear wheel axle 32r at a predetermined conversion ratio. Note that electric vehicle 3 may be a front wheel drive (2WD) electric vehicle 3 or a 4WD electric vehicle 3.

Power supply system 40 includes battery pack 41 and management unit 42. Battery pack 41 includes a plurality of cells connected in series or a plurality of cell blocks connected in series. Each cell block includes a plurality of single cells connected in parallel. In the case of battery pack 41 in which a large number of series connections of single cells or cell blocks is large, a plurality of battery modules including a plurality of single cells or a plurality of cell blocks connected in series may be connected in series to form battery pack 41.

Available examples of the cell include a lithium ion battery cell, and a nickel metal hydride battery cell. Hereinafter, the present description assumes an example of use of lithium ion battery cells (nominal voltage: 3.6 V to 3.7 V). The number of series connections of single cells or cell blocks is determined in accordance with voltage of motor 34.

Management unit 42 manages the state of battery pack 41. Management unit 42 monitors, as monitoring data items of battery pack 41, each cell voltage of a plurality of single cells or a plurality of cell blocks measured by a voltage sensor (not illustrated), a current flowing through battery pack 41 measured by a current sensor (not illustrated), and each temperature measured by a plurality of temperature sensors (not illustrated) installed in battery pack 41.

Management unit 42 acquires each cell voltage, the current, and each temperature being monitored at a predetermined sampling cycle (for example, 10 seconds), and stores the acquired voltages, currents, and temperatures in a nonvolatile memory (not illustrated). Management unit 42 may store only the maximum cell voltage and the minimum cell voltage of each cell voltage to compress the data storage amount. Management unit 42 may store only the maximum temperature and the minimum temperature of each temperature at the plurality of observation points to compress the data storage amount.

Management unit 42 estimates a State Of Charge (SOC) by combining an Open Circuit Voltage (OCV) method and a current integration method. The OCV method is a method of estimating the SOC based on the OCV of a cell to be measured and the SOC-OCV curve of the cell. The SOC-OCV curve of the cell is created in advance based on a characteristic test performed by a battery manufacturer, and is registered in management unit 42 at the time of shipment.

The current integration method is a method of estimating the SOC based on the OCV at the start of charging and discharging of a cell and an integration value of a measured current. The current integration method causes a measurement error of the current to accumulate as charging and discharging time increases. Thus, it is preferable to use a weighted average of the SOC estimated by the current integration method and the SOC estimated by the OCV method.

Management unit 42 can convert the SOC of each of single cells or each of cell blocks into an actual capacity, combine the actual capacities to calculate the actual capacity of battery pack 41, and estimate the SOC of battery pack 41 based on the actual capacity and the current full charge capacity of battery pack 41.

Management unit 42 transmits battery data including each cell voltage or maximum and minimum cell voltages, current, each temperature or maximum and minimum temperatures, and the SOC of battery pack 41, to vehicle controller 30 via an in-vehicle network. For example, a controller area network (CAN) or a local interconnect network (LIN) can be used as the in-vehicle network. In addition, management unit 42 transmits, to vehicle controller 30, battery information (such as model numbers) for specifying the types of the plurality of cells included in battery pack 41. The battery information only needs to be transmitted only once at an initial stage.

In the EV, a three-phase AC motor is generally used as driving motor 34. Inverter 35 converts DC power supplied from battery pack 41 into AC power, and supplies it to motor 34 at the time of power running. At the time of regeneration, AC power supplied from motor 34 is converted into DC power to be supplied to battery pack 41. At the time of power running, motor 34 rotates in accordance with AC power to be supplied from inverter 35. At the time of regeneration, rotational energy due to deceleration is converted into AC power and supplied to inverter 35.

Vehicle controller 30 is a vehicle electronic control unit (ECU) that controls entire electric vehicle 3, and may be configured with, for example, an integrated vehicle control module (VCM).

Vehicle speed sensor 36 generates a pulse signal proportional to the rotation speed of front wheel axle 32f or rear wheel axle 32r, and transmits the generated pulse signal to vehicle controller 30. Vehicle controller 30 detects the speed of electric vehicle 3 based on the pulse signal received from vehicle speed sensor 36.

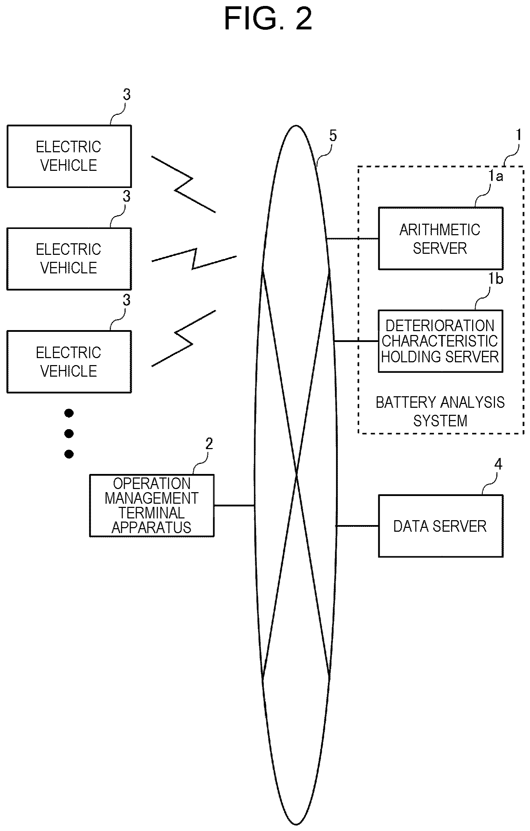

Wireless communication unit 37 includes a modem for wirelessly connecting to network 5 (see Fig. 2) via antenna 37a, and performs wireless signal processing. For example, there can be used a mobile phone network (cellular network), a wireless local area network (LAN), electronic toll collection system (ETC), dedicated short range communications (DSRC), vehicle-to-infrastructure (V2I), and vehicle-to-vehicle (V2V).

During running of electric vehicle 3, vehicle controller 30 can transmit running data from wireless communication unit 37 to data server 4 (see Fig. 2) via network 5 in real time. The running data includes at least a vehicle speed of electric vehicle 3, an accumulated running distance, and battery data received from management unit 42. Vehicle controller 30 samples these data periodically (for example, an interval of 10 seconds) and transmits the data to data server 4 each time. At the time of initial transmission, vehicle controller 30 also transmits battery information (such as a model number) to data server 4.

Vehicle controller 30 may store the running data of electric vehicle 3 in an internal memory and collectively transmit the running data stored in the memory at a predetermined timing. For example, vehicle controller 30 may collectively transmit the running data stored in the memory to operation management terminal apparatus 2 (see Fig. 2) installed in the delivery company base after the end of business in one day. Operation management terminal apparatus 2 transmits running data of the plurality of electric vehicles 3 to data server 4 each time at a predetermined timing.

Vehicle controller 30 may collectively transmit the running data stored in the memory to the charger via the charging cable at the time of charging from the charger having the network communication function. The charger transmits the received running data to data server 4. This example is effective for electric vehicle 3 not equipped with a wireless communication function.

Fig. 2 is a diagram for describing battery analysis system 1 according to an exemplary embodiment. Battery analysis system 1 according to the exemplary embodiment is a system to be used by at least one delivery company. For example, battery analysis system 1 may be constructed on an own server installed in an own facility or a data center of a company that provides an analysis service of a battery pack 41 mounted on electric vehicle 3. Battery analysis system 1 also may be constructed on a cloud server to be used based on a cloud service. Battery analysis system 1 also may be constructed on a plurality of servers dispersedly installed in a plurality of bases (a data center, an own facility). The plurality of servers may be a combination of a plurality of own servers, a combination of a plurality of cloud servers, or a combination of own servers and cloud servers. In the example illustrated in Fig. 2, battery analysis system 1 is constructed with arithmetic server 1a and deterioration characteristic holding server 1b.

The delivery company has a plurality of electric vehicles 3 and has a delivery base for parking electric vehicles 3.

Operation management terminal apparatus 2 is installed at the delivery base. Operation management terminal apparatus 2 is configured with a PC, for example. Operation management terminal apparatus 2 is used to manage the plurality of electric vehicles 3 belonging to the delivery base. The operation administrator of the delivery company can create an operation plan of the plurality of electric vehicles 3 using operation management terminal apparatus 2.

Operation management terminal apparatus 2 can access battery analysis system 1 via network 5. Operation management terminal apparatus 2 acquires the analysis result of the internal state and reuse determination result of battery pack 41 mounted on each electric vehicle 3, from battery analysis system 1. The internal state of battery pack 41 includes current and future internal deterioration states (storage deterioration, charge deterioration, and discharge deterioration). The analysis result of the internal state of battery pack 41 includes an abnormality sign detection result of battery pack 41. The reuse determination result of battery pack 41 includes the end time of the primary use and the determination result of the secondary use destination.

Data server 4 acquires running data from operation management terminal apparatus 2 or electric vehicle 3 and stores it. Data server 4 may be an own server installed in an own facility or a data center of a delivery company or a battery analysis service company, or may be a cloud server to be used by the delivery company or the battery analysis service company. Each of the delivery company and the battery analysis service company may have data server 4.

Network 5 is a general term for communication paths such as the Internet, a dedicated line, and a virtual private network (VPN), and the communication medium and the protocol thereof are not limited. The communication media to be used may be, for example, a mobile phone network (cellular network), a wireless local area network (LAN), a wired LAN, an optical fiber network, an ADSL network, or a CATV network. Available examples of the communication protocol include transmission control protocol (TCP)/internet protocol (IP), user datagram protocol (UDP)/IP, and Ethernet (registered trademark).

In a state in which electric vehicle 3 is parked at the delivery base, vehicle controller 30 and operation management terminal apparatus 2 can exchange data via network 5(for example, a wireless LAN), a CAN cable, or the like. Vehicle controller 30 and operation management terminal apparatus 2 may also be configured to be able to exchange data via network 5 during running of electric vehicle 3.

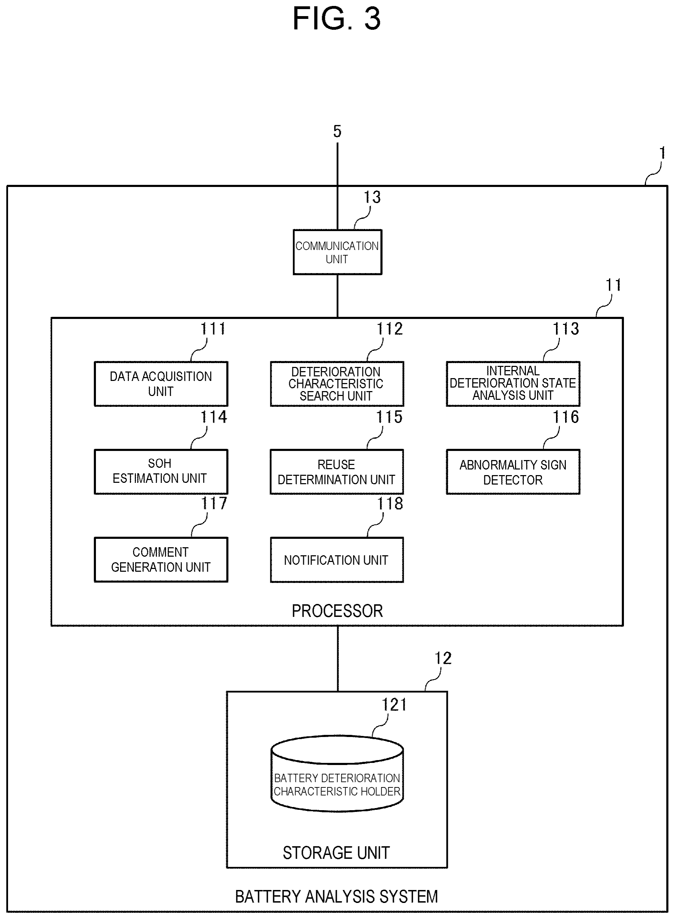

Fig. 3 is a diagram illustrating a configuration example of battery analysis system 1 according to the exemplary embodiment. Battery analysis system 1 includes processor 11, storage unit 12, and communication unit 13. Communication unit 13 is a communication interface (for example, NIC: network interface card) for connection to network 5 in a wired manner or a wireless manner.

Processor 11 includes data acquisition unit 111, deterioration characteristic search unit 112, internal deterioration state analysis unit 113, SOH estimation unit 114, reuse determination unit 115, abnormality sign detector 116, comment generation unit 117, and notification unit 118. Functions of processor 11 can be achieved by cooperation of a hardware resource and a software resource, or by a hardware resource alone. Available examples of the hardware resource include a CPU, a ROM, a RAM, a graphics processing unit (GPU), an application specific integrated circuit (ASIC), a field programmable gate array (FPGA), and other LSI circuits. Available examples of the software resource include a program, such as an operating system or an application. The program may be recorded in a recording medium. When this recording medium is used, the program can be installed in the computer, for example. Here, the recording medium on which the program is recorded may be a non-transitory recording medium. Although the non-transitory recording medium is not particularly limited, it may be a recording medium such as a CD-ROM, for example.

Storage unit 12 includes a nonvolatile recording medium such as an HDD or an SSD, and stores various kinds of data. Storage unit 12 includes battery deterioration characteristic holder 121. Battery deterioration characteristic holder 121 holds a storage deterioration characteristic, a storage deterioration rate coefficient ps, a charge deterioration characteristic, a charge deterioration rate coefficient pc, a discharge deterioration characteristic, and a discharge deterioration rate coefficient pd for each type of secondary battery.

Battery deterioration characteristic holder 121 holds at least one of information such as a model number, a model, a cell shape, a positive electrode material, a composition ratio of the positive electrode material, a negative electrode material, a composition ratio of the negative electrode material, an energy weight density, and an energy volume density, as battery information for specifying the type of the secondary battery. The data in battery deterioration characteristic holder 121 is updated each time a new type of secondary battery is registered. In addition, when the characteristic information of the registered secondary battery is updated, the data in battery deterioration characteristic holder 121 is also updated.

The storage deterioration is deterioration that progresses over time depending on the temperature at each time point and the SOC at each time point of the secondary battery. The storage deterioration progresses as time goes, regardless of whether charge or discharge is being performed. The storage deterioration mainly occurs due to formation of a film (solid electrolyte interphase (SEI) film) on a negative electrode. The storage deterioration depends on the SOC and temperature at each time point. In general, the higher the SOC at each time point is or the higher the temperature at each time point is, the more a storage deterioration rate increases.

Charge and discharge deterioration of the secondary battery is a deterioration that progresses as the number of times of charge and discharge increases. The charge and discharge deterioration mainly occurs due to cracking or peeling by expansion or contraction of an active material. The charge and discharge deterioration depends on the used SOC range, the temperature, and the current rate. In general, the wider the SOC range used, the higher the temperature, and the higher the current rate, the higher the charge and discharge deterioration rate.

The storage deterioration characteristic, the charge deterioration characteristic, and the discharge deterioration characteristic are derived in advance for each type of secondary battery by an experiment or simulation by a battery manufacturer.

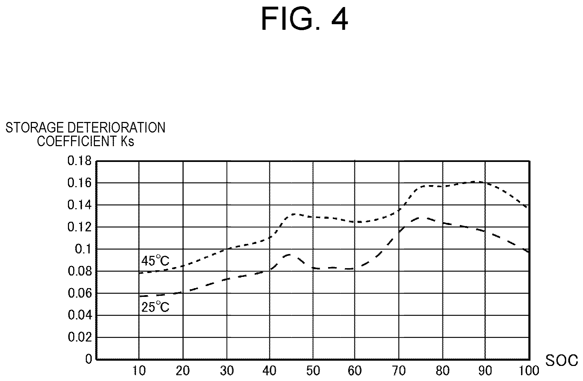

Fig. 4 is a diagram illustrating an example of a storage deterioration characteristic map. The horizontal axis represents SOC [%], and the vertical axis represents the storage deterioration coefficient Ks. In general, the storage deterioration progresses substantially linearly with respect to a value obtained by raising elapsed time (h) to the power of 0.5 (square root). Depending on a type of the secondary battery, the storage deterioration may progress substantially linearly with respect to a value obtained by raising elapsed time (h) to the power of 0.4, a value obtained by raising elapsed time (h) to the power of 0.6, or the like. In the present description, a coefficient to be multiplied by the elapsed time (h) is referred to as a storage deterioration rate coefficient ps.

In Fig. 4, for the sake of simplicity, only the storage deterioration characteristics for two types of temperatures "temp" of 25°C and 45°C are illustrated, but actually, storage deterioration characteristics for a large number of temperatures are generated. The storage deterioration characteristic may be defined not by a map but by a storage deterioration characteristic model (function) in which the SOC and the temperature "temp" are used as explanatory variables and the storage deterioration coefficient Ks is used as an objective variable.

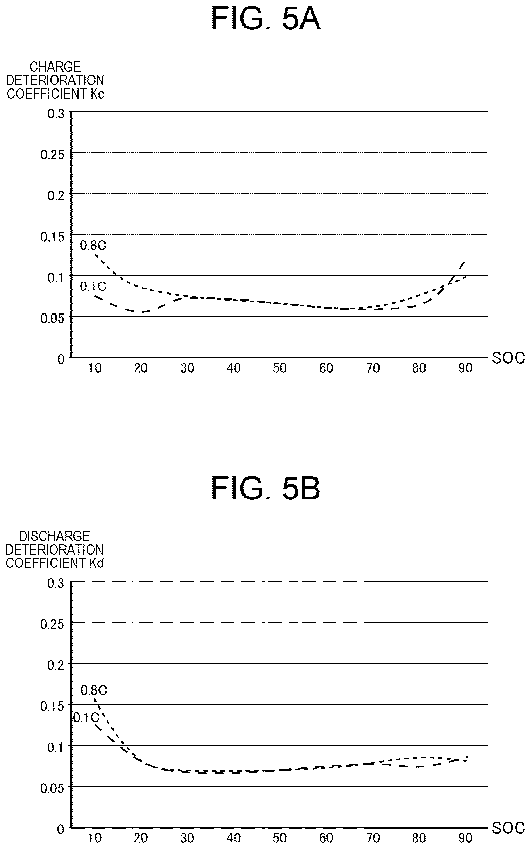

Figs. 5A and 5B are diagrams each illustrating an example of a charge and discharge deterioration characteristic map. Fig. 5A illustrates an example of a charge deterioration characteristic map, and Fig. 5B illustrates an example of a discharge deterioration characteristic map. The horizontal axis represents the use range of SOC [%]. In Figs. 5A and 5B, the value of each SOC indicates the lower limit value of the use range of 10%. For example, SOC 10% indicates charging and discharging in a range of SOC 10% to 20%, and SOC 11% indicates charging and discharging in a range of SOC 11% to 21%. The vertical axes represent charge deterioration coefficient Kc and discharge deterioration coefficient Kd.

In general, the charge and discharge deterioration progresses substantially linearly with respect to a value obtained by raising total charge amount (Ah) or total discharge amount (Ah) to the power of 0.5 (square root). Depending on the type of the secondary battery, the charge and discharge deterioration may progress substantially linearly with respect to a value obtained by raising the total charge amount (Ah) or the total discharge amount (Ah) to the power of 0.4 or a value obtained by raising the total charge amount (Ah) or total discharge amount (Ah) to the power of 0.6. In the present description, a coefficient to be multiplied by the charge amount (Ah) is referred to as a charge deterioration rate coefficient pc, and a coefficient to be multiplied by the total discharge amount (Ah) is referred to as a discharge deterioration rate coefficient pd.

In Figs. 5A and 5B, for the sake of simplicity, only charge and discharge deterioration characteristics for two types of current rates of 0.1 C and 0.8 C are illustrated, but actually, charge and discharge deterioration characteristics for a large number of current rates are generated. At the time of charging, as illustrated in Fig. 5A, it can be seen that the charge and discharge deterioration rate increases in a region in which the use range of the SOC is low and a region in which the use range of the SOC is high. At the time of discharging, as illustrated in Fig. 5B, it can be seen that the charge and discharge deterioration rate increases in a region in which the use range of the SOC is low.

In addition, the charge and discharge deterioration characteristics are also affected by the temperature "temp" that does not contribute as much as the current rate "rate". For this reason, in order to increase the estimation accuracy of the charge and discharge deterioration rate, it is preferable to prepare a charge and discharge deterioration characteristic defining the relationship between the SOC use ranges, and the charge deterioration coefficients Kc and discharge deterioration coefficients Kd for each of two-dimensional combinations of the plurality of current rates "rate" and the plurality of temperatures "temp". In contrast, in a case in which a simple charge and discharge deterioration characteristic map is generated, it is only necessary that the temperature is regarded as a normal temperature, and a charge and discharge deterioration characteristic is prepared for each of a plurality of current rates.

The charge and discharge deterioration characteristic may be defined not by a map but by a charge and discharge deterioration characteristic model (function) in which the SOC use range, the current rate "rate", and the temperature "temp" are used as explanatory variables, and charge deterioration coefficient Kc and discharge deterioration coefficient Kd are used as objective variables. Note that the temperature "temp" may be a constant.

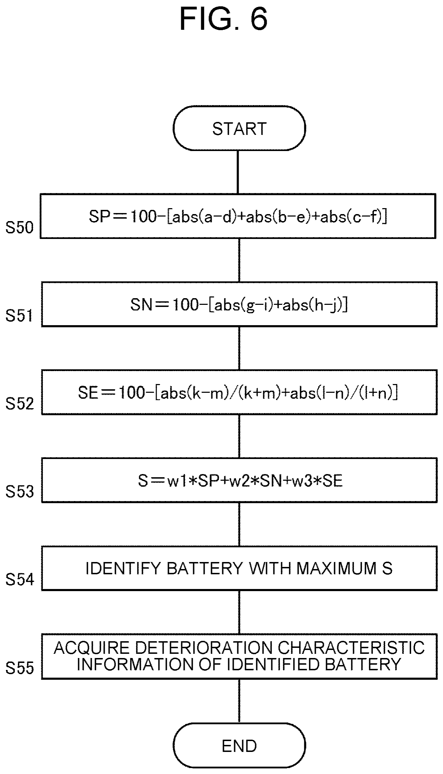

Fig. 6 is a flowchart for describing an example of a search method for a deterioration characteristic. In the example illustrated in Fig. 6, it is assumed that a ternary material (NCM) is used for a positive electrode material and a mixed material of graphite and silicon is used for a negative electrode material, of a cell that is a search target. The composition ratio of the positive electrode material of the target cell is a: b: c (for example, NCM532), and the composition ratio of the positive electrode material of the reference cell in the database is d: e: f. In addition, the composition ratio of the negative electrode material of the target cell is g: h (for example, graphite 97: silicon 3), and the composition ratio of the negative electrode material of the reference cell in the database is i:j. In addition, the energy weight density [wh/kg] of the target cell is denoted by k, the energy volume density [wh/L] thereof is denoted by 1, the energy weight density [wh/kg] of the reference cell is denoted by m, and the energy volume density [wh/L] thereof is denoted by n.

Deterioration characteristic search unit 112 calculates the positive electrode material similarity SP between the target cell and the reference cell (S50) with the following (Expression 1), calculates the negative electrode material similarity SN (S51) with the following (Expression 2), and calculates the energy density similarity SE (S52) with the following (Expression 3). In any expression, the higher the similarity, the higher the score.

$$SP = 100 - [abs(a - d) + abs(b - e) + abs(c - f)] \ ... \ (Expression \ 1)$$

$$SN = 100 - [abs(g - i) + abs(h - j)] \ ... \ (Expression \ 2)$$

$$SE = 100 - [abs(k - m)/(k + m) + abs(l - n)/(l + n)] \ ... \ (Expression \ 3)$$

Deterioration characteristic search unit 112 calculates the total similarity S between the target cell and the reference cell (S53) with the following (Expression 4). Coefficients w1, w2, and w3 (w1 + w2 + w3 = 1) are weighting coefficients. The coefficients w1, w2, and w3 are determined based on evaluation results based on experiments and simulations, and knowledge of a designer.

$$S = w1 * SP + w2 * SN + w3 * SE \ ... \ (Expression \ 4)$$

Deterioration characteristic search unit 112 calculates the total similarity S between the target cell and the plurality of reference cells, and identifies the reference cell having the highest total similarity S (S54). Deterioration characteristic search unit 112 acquires deterioration characteristic information of the identified cell (S55).

The description returns to Fig. 3. Internal deterioration state analysis unit 113 estimates a storage deterioration amount, a charge deterioration amount, and a discharge deterioration amount of battery pack 41 based on use history data (current, temperature, SOC) of battery pack 41 indicating a charge and discharge history of battery pack 41 and deterioration characteristic information identified by deterioration characteristic search unit 112. As the temperature of battery pack 41, an average temperature of a plurality of observation points in battery pack 41 may be used, an average temperature of a maximum temperature and a minimum temperature may be used, or a maximum temperature may be used.

Internal deterioration state analysis unit 113 estimates the storage deterioration amount of battery pack 41 based on the storage deterioration characteristic identified by deterioration characteristic search unit 112, the SOC based on the use history data of battery pack 41, the temperature, and the elapsed time. In addition, internal deterioration state analysis unit 113 estimates the charge deterioration amount of battery pack 41 based on the charge deterioration characteristic identified by deterioration characteristic search unit 112, the SOC based on the use history data of battery pack 41, the charge rate, the temperature, and the charge amount. In addition, internal deterioration state analysis unit 113 estimates the discharge deterioration amount of battery pack 41 based on the discharge deterioration characteristic identified by deterioration characteristic search unit 112, the SOC based on the use history data of battery pack 41, the discharge rate, the temperature, and the discharge amount.

SOH estimation unit 114 adds the storage deterioration amount, the charge deterioration amount, and the discharge deterioration amount of battery pack 41 estimated by internal deterioration state analysis unit 113 to estimate the SOH of battery pack 41. When estimating the SOH of battery pack 41, SOH estimation unit 114 may correct the storage deterioration amount of battery pack 41 using the SOH at the time of storage of battery pack 41. In addition, SOH estimation unit 114 may correct the charge deterioration amount of battery pack 41 using a depth of discharge (DOD) changed in the current charging of battery pack 41. In addition, SOH estimation unit 114 may correct the discharge deterioration amount of battery pack 41 using the DOD changed in the current discharging of battery pack 41.

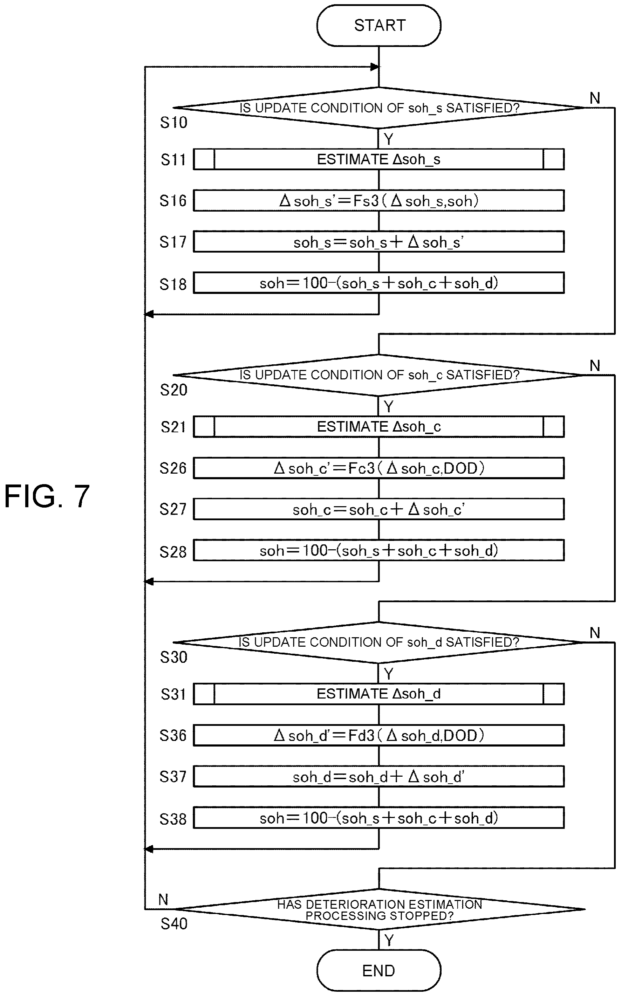

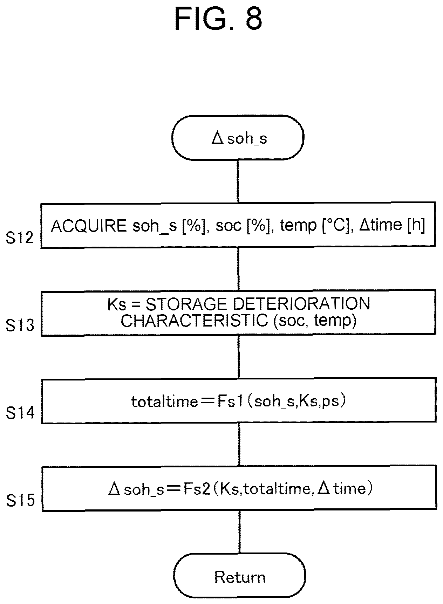

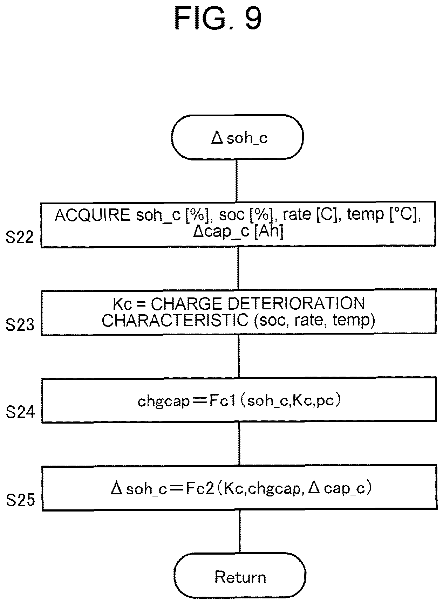

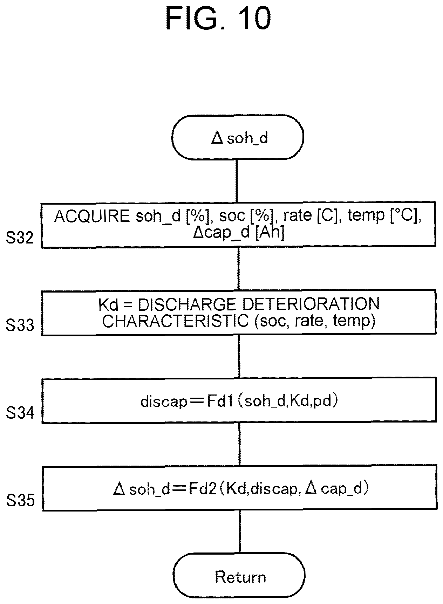

Fig. 7 is a flowchart for describing estimation processing of an SOH according to the exemplary embodiment. Fig. 8 is a flowchart illustrating a subroutine for describing the processing of estimating the storage deterioration increase amount Δsoh_s. Fig. 9 is a flowchart illustrating a subroutine for describing the processing of estimating the charge deterioration increase amount Δsoh_c. Fig. 10 is a flowchart illustrating a subroutine for describing the processing of estimating the discharge deterioration increase amount Δsoh_d.

In Fig. 7, when the update condition of the storage deterioration amount soh_s is satisfied (Y in S10), internal deterioration state analysis unit 113 executes estimation processing of the storage deterioration increase amount Δsoh_s (S11). The update condition of the storage deterioration amount soh_s may be the elapse of a predetermined time (for example, 24 hours) or a predetermined change in the temperature of battery pack 41.

In Fig. 8, internal deterioration state analysis unit 113 acquires the latest storage deterioration amount soh_s [%], SOC [%], temperature "temp" [°C], and elapsed time Δtime [h] of battery pack 41 as input parameters (S12). Internal deterioration state analysis unit 113 acquires the storage deterioration characteristic and the storage deterioration rate coefficient ps included in the stored deterioration information identified by deterioration characteristic search unit 112. Internal deterioration state analysis unit 113 inputs the acquired SOC and temperature "temp" to the acquired storage deterioration characteristic to acquire the storage deterioration coefficient Ks (S13).

Internal deterioration state analysis unit 113 inputs the acquired latest storage deterioration amount soh_s, storage deterioration coefficient Ks, and storage deterioration rate coefficient ps to a predetermined total elapsed time derivation function Fs1 to acquire a simulated total elapsed time "totaltime" (S14). Internal deterioration state analysis unit 113 inputs the acquired storage deterioration coefficient Ks, the simulated total elapsed time "totaltime", and the elapsed time Δtime to the predetermined storage deterioration amount derivation function Fs2 to estimate the storage deterioration increase amount Δsoh_s (S15).

The description returns to Fig. 7. Internal deterioration state analysis unit 113 inputs the acquired storage deterioration increase amount Δsoh_s and the current SOH to the predetermined storage deterioration amount correction function Fs3 to estimate the corrected storage deterioration increase amount Δsoh_s' (S16). Internal deterioration state analysis unit 113 adds the corrected storage deterioration increase amount Δsoh_s' to the current storage deterioration amount soh_s to update the storage deterioration amount soh_s (S17). SOH estimation unit 114 subtracts a value obtained by adding the updated storage deterioration amount soh_s, the current charge deterioration amount soh_c, and the current discharge deterioration amount soh_d from 100 to calculate the latest SOH (S18). Return to step S10.

When the update condition of the charge deterioration amount soh_c is satisfied (Y in S20), internal deterioration state analysis unit 113 executes estimation processing of the charge deterioration increase amount Δsoh_c (S21). The update condition of the charge deterioration amount soh_c may be the elapse of a predetermined time (for example, 24 hours) or a predetermined change (for example, a 5% change) in the SOC of battery pack 41.

In Fig. 9, internal deterioration state analysis unit 113 acquires the latest charge deterioration amount soh_c [%], SOC [%], charge rate "rate" [C], temperature "temp" [°C], and charge amount Δcap_c [Ah] of battery pack 41, as input parameters (S22). Internal deterioration state analysis unit 113 acquires the charge deterioration characteristic and the charge deterioration rate coefficient pc included in the charge deterioration information identified by deterioration characteristic search unit 112. Internal deterioration state analysis unit 113 inputs the acquired SOC, charge rate "rate", and temperature "temp" to the acquired charge deterioration characteristic to acquire the charge deterioration coefficient Kc (S23).

Internal deterioration state analysis unit 113 inputs the acquired latest charge deterioration amount soh_c, charge deterioration coefficient Kc, and charge deterioration rate coefficient pc to a predetermined total charge amount derivation function Fc1 to acquire a simulated total charge amount "chgcap" (S24). Internal deterioration state analysis unit 113 inputs the acquired charge deterioration coefficient Kc, the simulated total charge amount "chgcap", and the charge amount Δcap_c to the predetermined charge deterioration amount derivation function Fc2 to estimate the charge deterioration increase amount Δsoh_c (S25).

The description returns to Fig. 7. Internal deterioration state analysis unit 113 inputs the acquired charge deterioration increase amount Δsoh_c and the DOD changed in the current charging cycle to a predetermined charge deterioration amount correction function Fc3 to estimate the corrected charge deterioration increase amount Δsoh_c' (S26). Internal deterioration state analysis unit 113 adds the corrected charge deterioration increase amount Δsoh_c' to the current charge deterioration amount soh_c to update the charge deterioration amount soh_c (S27). SOH estimation unit 114 subtracts a value obtained by adding the updated charge deterioration amount soh_c, the current storage deterioration amount soh_s, and the current discharge deterioration amount soh_d from 100 to calculate the latest SOH (S28). Return to step S10.

When the update condition of the discharge deterioration amount soh_d is satisfied (Y in S30), internal deterioration state analysis unit 113 executes estimation processing of the discharge deterioration increase amount Δsoh_d (S31). The update condition of the discharge deterioration amount soh_d may be the elapse of a predetermined time (for example, 24 hours) or a predetermined change (for example, a 5% change) in the SOC of battery pack 41.

In Fig. 10, internal deterioration state analysis unit 113 acquires the latest discharge deterioration amount soh_d [%], SOC [%], discharge rate "rate" [C], temperature "temp" [°C], and discharge amount Δcap_d [Ah] of battery pack 41, as input parameters (S32). Internal deterioration state analysis unit 113 acquires the discharge deterioration characteristic and the discharge deterioration rate coefficient pd included in the discharge deterioration information identified by deterioration characteristic search unit 112. Internal deterioration state analysis unit 113 inputs the acquired SOC, discharge rate "rate", and temperature "temp" to the acquired discharge deterioration characteristics to acquire the discharge deterioration coefficient Kd (S33).

Internal deterioration state analysis unit 113 inputs the acquired latest discharge deterioration amount soh_d, discharge deterioration coefficient Kd, and discharge deterioration rate coefficient pd to a predetermined total discharge amount derivation function Fd1 to acquire a simulated total discharge amount "discap" (S34). Internal deterioration state analysis unit 113 inputs the acquired discharge deterioration coefficient Kd, the simulated total discharge amount "discap", and the discharge amount Δcap_d to a predetermined discharge deterioration amount derivation function Fd2 to estimate the discharge deterioration increase amount Δsoh_d (S35).

The description returns to Fig. 7. Internal deterioration state analysis unit 113 inputs the acquired discharge deterioration increase amount Δsoh_d and the DOD changed in the current discharge cycle to a predetermined discharge deterioration amount correction function Fd3 to estimate a corrected discharge deterioration increase amount Δsoh_d' (S36). Internal deterioration state analysis unit 113 adds the corrected discharge deterioration increase amount Δsoh_d' to the current discharge deterioration amount soh_d to update the discharge deterioration amount soh_d (S37). SOH estimation unit 114 subtracts a value obtained by adding the updated discharge deterioration amount soh_d, the current storage deterioration amount soh_s, and the current charge deterioration amount soh_c from 100 to calculate the latest SOH (S38). The above processing is continuously executed until the internal deterioration state estimation processing is stopped (Y in S40) (N in S40).

SOH estimation unit 114 predicts a future SOH of battery pack 41 based on a current SOH of battery pack 41 and a predicted charge and discharge pattern of battery pack 41. For example, SOH estimation unit 114 calculates a daily average running distance based on running data acquired from electric vehicle 3. SOH estimation unit 114 makes a trial calculation of a daily average charge and discharge pattern corresponding to the daily average running distance. SOH estimation unit 114 assumes that the daily average charge and discharge pattern continues every day in the future, and executes the algorithm illustrated in Figs. 7 to 10 to predict the SOH after X days.

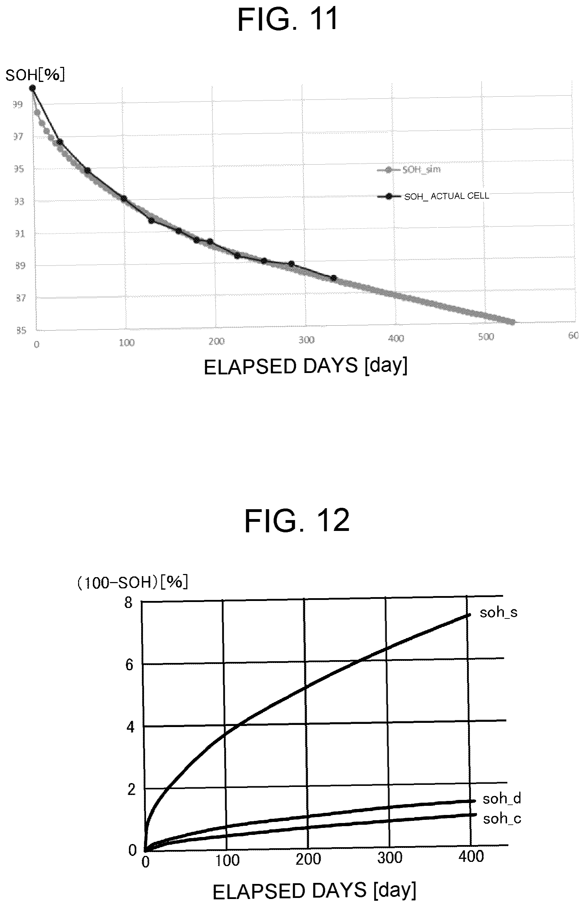

Fig. 11 is a diagram comparing the SOH of the cell simulated by the internal deterioration state estimation method according to the exemplary embodiment with the time transition of the SOH of the cell based on the actual measurement result. The example illustrated in Fig. 11 is based on charge and discharge data corresponding to a running pattern specified in the JC08 mode. The measured SOH is a value measured by charging and discharging an actual cell using a charge and discharge test apparatus. It has been confirmed that the time transition of the SOH calculated by the internal deterioration state estimation method according to the exemplary embodiment is substantially the same as the time transition of the SOH of the actual cell (error < 5%).

Reuse determination unit 115 periodically (for example, once every 3 months, once every 6 months) executes the reuse determination processing for battery pack 41 using the analysis result of the internal deterioration state of battery pack 41 analyzed by internal deterioration state analysis unit 113. Specifically, reuse determination unit 115 determines the secondary use destination after the end of primary use of battery pack 41 based on the breakdown of the storage deterioration amount soh_s, the charge deterioration amount soh_c, and the discharge deterioration amount soh_d of battery pack 41 estimated by internal deterioration state analysis unit 113. A specific example of the secondary use destination is described below. When the reuse determination processing is executed, it is not necessary to measure the capacity of battery pack 41, and it is also not necessary to construct a battery chemical reaction model.

Fig. 12 is a diagram illustrating an example of analysis result of a breakdown of the storage deterioration amount soh_s, the charge deterioration amount soh_c, and the discharge deterioration amount soh_d. In the example illustrated in Fig. 12, the storage deterioration amount soh_s is the largest, and is a main factor of deterioration of battery pack 41.

Reuse determination unit 115 can also determine the end time of the primary use of battery pack 41 based on the future SOH time transition of battery pack 41 predicted by SOH estimation unit 114.

Based on the use history data of battery pack 41, abnormality sign detector 116 executes abnormality sign detection processing for detecting in advance an abnormality that has not been actualized in battery pack 41. The abnormality sign detection processing is a process executed separately from the reuse determination processing, and is executed more frequently than the reuse determination processing.

For example, as the abnormality sign detection of battery pack 41, abnormality sign detector 116 detects whether a cell having a micro-short circuit inside is included. In an example of the method for detecting a micro-short circuit, each cell voltage included in the use history data of battery pack 41 is used. Abnormality sign detector 116 generates a smoothing voltage of each cell voltage in time series. For example, abnormality sign detector 116 may generate a smoothing voltage of each cell voltage using a primary lowpass filter, or may calculate a moving average of each cell voltage in a certain period to generate a smoothing voltage of each cell voltage.

Abnormality sign detector 116 calculates a representative value of the smoothing voltages of a plurality of single cells or cell blocks included in battery pack 41 except the smoothing voltage of the target single cell or cell block. For example, a median, an average, and a mode of smoothing voltages except the smoothing voltage of the target single cell or cell block are calculated as the representative values. Abnormality sign detector 116 calculates a difference between the smoothing voltage of the target single cell or cell block and a representative value of the smoothing voltages of the other single cells or cell blocks.

Based on the change in the difference in the predetermined period, abnormality sign detector 116 determines the risk of the micro-short circuit in three stages of normal "N", warning "W", and abnormality "E". For example, when the difference increases by a first set value or more in a predetermined period, abnormality sign detector 116 determines that a target single cell or cell block is in a micro-short circuit (abnormality "E"). For example, when the difference increases by 5 mV or more in 12 hours, it is determined that a micro-short circuit has occurred.

When the difference increases by less than a second set value in the predetermined period, abnormality sign detector 116 determines that the target single cell or cell block is not in a micro-short circuit (normal "N"). When the change in the difference in the predetermined period is between the first set value and the second set value, abnormality sign detector 116 determines that the target single cell or cell block is in early stages of a micro-short circuit (warning "W").

Abnormality sign detector 116 detects, for example, an abnormality of voltage across the cell included in battery pack 41 as another abnormality sign detection of battery pack 41. In an example of the method for detecting the cell voltage abnormality, there are used the maximum cell voltage and the minimum cell voltage included in the use history data of battery pack 41. Based on the difference between the maximum cell voltage and the minimum cell voltage, abnormality sign detector 116 determines the risk of a voltage abnormality in three stages of normal "N", warning [W], and abnormality "E".

For example, when the difference between the maximum cell voltage and the minimum cell voltage is larger than or equal to a third set value, abnormality sign detector 116 determines that a voltage abnormality has occurred (abnormality "E"). When the difference between the maximum cell voltage and the minimum cell voltage is less than a fourth set value, abnormality sign detector 116 determines that no voltage abnormality occurs (normal "N"). When the difference between the maximum cell voltage and the minimum cell voltage is between the third set value and the fourth set value, abnormality sign detector 116 determines that the cell is in early stages of the voltage abnormality (warning "W").

When the result of the abnormality sign detection of battery pack 41 detected by abnormality sign detector 116 is the warning level "W", reuse determination unit 115 determines the secondary use destination of battery pack 41 regardless of the current SOH of battery pack 41.

When reuse determination unit 115 determines the secondary use destination of battery pack 41, comment generation unit 117 generates a comment on the usage condition of battery pack 41 at the secondary use destination. A specific example of the comment is described below.

When abnormality sign detector 116 executes the reuse determination processing for battery pack 41, notification unit 118 notifies the reuse determination result of battery pack 41, via network 5, to operation management terminal apparatus 2 of the delivery company or the terminal device of the vehicle management department. When the secondary use destination is determined, a comment on the usage condition at the secondary use destination is also added to the reuse determination result. When electric vehicle 3 is owned by an individual, notification unit 118 may notify the reuse determination result of battery pack 41 mounted on electric vehicle 3 to a terminal device of a dealer, a vehicle inspection specialty shop, a gas station, or a maintenance factory that performs a vehicle inspection of electric vehicle 3.

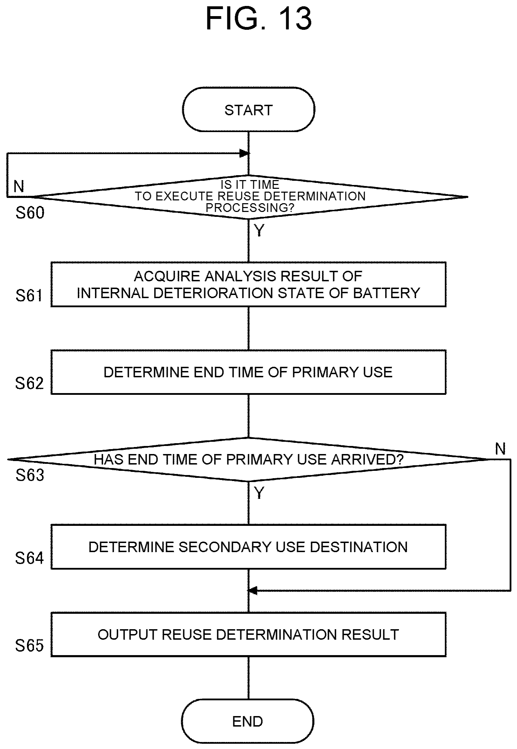

Fig. 13 is a flowchart illustrating an overall flow of the reuse determination processing for battery pack 41 according to the exemplary embodiment. When the execution time of the reuse determination processing for battery pack 41 arrives (Y in S60), reuse determination unit 115 acquires an analysis result of the internal deterioration state of battery pack 41 (S61). Reuse determination unit 115 determines the end time of the primary use of battery pack 41 based on the SOH of battery pack 41 included in the analysis result of the internal deterioration state (S62).

When the end time of the primary use has arrived (Y in S63), reuse determination unit 115 determines the secondary use destination of battery pack 41 (S64). When the end time of the primary use has not arrived (N in S63), the processing in step S64 is skipped. Reuse determination unit 115 outputs the reuse determination result of battery pack 41 (S65).

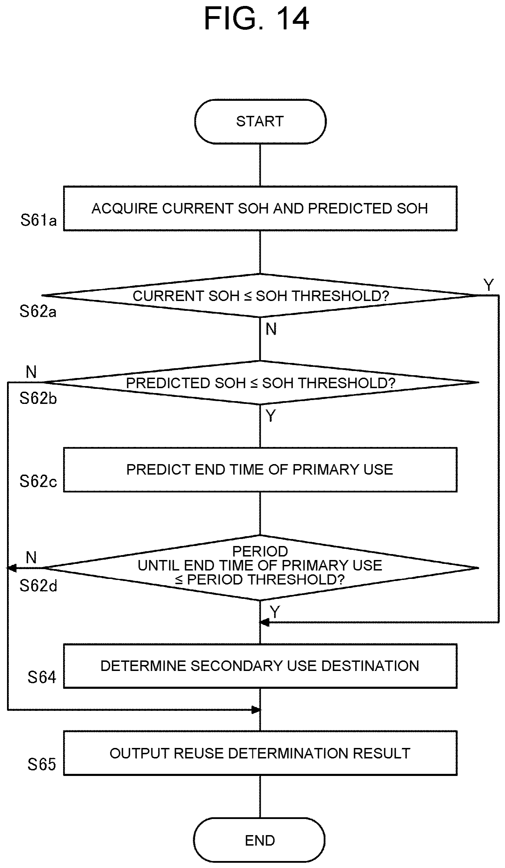

Fig. 14 is a flowchart for describing a specific example of the processing of determining the end time of the primary use. Reuse determination unit 115 acquires the current SOH and the predicted SOH of battery pack 41, as the analysis result of the internal deterioration state of battery pack 41 (S61a). Reuse determination unit 115 compares the current SOH of battery pack 41 with the SOH threshold (S62a) thereof. The SOH threshold is an End Of Life (EOL) value for primary use set in advance. When the current SOH of battery pack 41 is lower than or equal to the SOH threshold (Y in S62a), reuse determination unit 115 determines the secondary use destination of battery pack 41 (S64), and outputs the reuse determination result of battery pack 41 (S65).

When the current SOH of battery pack 41 is higher than the SOH threshold (N in S62a), reuse determination unit 115 compares the predicted SOH of battery pack 41 with the SOH threshold (S62b). The predicted SOH is set to, for example, a predicted value of an SOH three months ahead or six months ahead.

When the predicted SOH of battery pack 41 is higher than the SOH threshold (N in S62b), reuse determination unit 115 outputs the reuse determination result of battery pack 41 without determining the secondary use destination of battery pack 41 (S65). When the predicted SOH of battery pack 41 is equal to or lower than the SOH threshold (Y in S62b), reuse determination unit 115 predicts the end time of the primary use of battery pack 41 based on the predicted time transition of the SOH of battery pack 41 (S62c).

Reuse determination unit 115 compares the period until the end time of the primary use with a period threshold (S62d). The period threshold is set to, for example, about one month. When the period until the end time of the primary use is longer than the period threshold (N in S62 d), reuse determination unit 115 outputs the reuse determination result of battery pack 41 without determining the secondary use destination of battery pack 41 (S65). When the period until the end time of the primary use is less than or equal to the period threshold (Y in S62 d), reuse determination unit 115 determines the secondary use destination of battery pack 41 (S64) at the time point when the prediction time arrives, and outputs the reuse determination result of battery pack 41 (S65).

In the flowchart illustrated in Fig. 14, the current SOH or the predicted SOH is compared with the SOH threshold to determine the end time of the primary use. However, the current or future storage deterioration amount soh_s, the charge deterioration amount soh_c, and the discharge deterioration amount soh_d may be compared with the respective deterioration thresholds to determine the end time of the primary use.

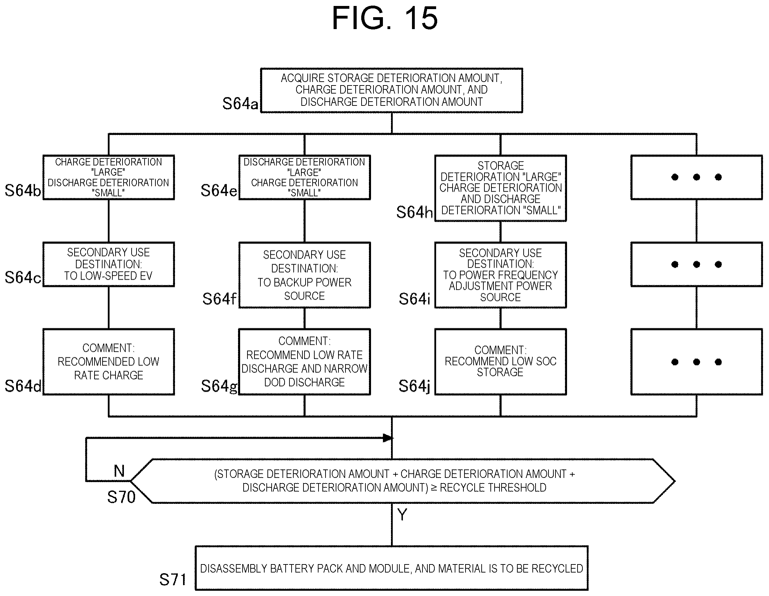

Fig. 15 is a flowchart for describing Specific Example 1 of the processing of determining the secondary use destination. Reuse determination unit 115 holds a secondary use destination determination table in which patterns of breakdown ratios of the storage deterioration amount soh_s, the charge deterioration amount soh_c, and the discharge deterioration amount soh_d set in advance are associated with secondary use destinations. Reuse determination unit 115 acquires the storage deterioration amount soh_s, the charge deterioration amount soh_c, and the discharge deterioration amount soh_d of battery pack 41 generated by internal deterioration state analysis unit 113 (S64a).

Reuse determination unit 115 refers to the secondary use destination determination table and determines the secondary use destination of battery pack 41 based on the acquired storage deterioration amount soh_s, charge deterioration amount soh_c, and discharge deterioration amount soh_d of battery pack 41.

For example, when "the breakdown ratio of the storage deterioration amount soh_s":"the charge deterioration amount soh_c":"the discharge deterioration amount soh_d" of battery pack 41 is "medium":" large":"small" (S64b), reuse determination unit 115 determines that the secondary use destination is a low-speed EV that is not compatible with rapid charging (S64c). Comment generation unit 117 generates a comment such as "To reduce charge deterioration, charging at a low rate is recommended" as a usage condition when battery pack 41 is secondarily used for a low-speed EV that is not compatible with rapid charging, for example (S64d). Adding this comment clearly indicates that the defect of battery pack 41 due to charging at a high rate is out of the guarantee range.

For example, when the breakdown ratio of "the storage deterioration amount soh_s" : "the charge deterioration amount soh_c" : "the discharge deterioration amount soh_d" of battery pack 41 is "medium" : "small" : "large" (S64e), reuse determination unit 115 determines that the secondary use destination is a power storage system for the backup power source (S64f). Comment generation unit 117 generates a comment such as "To reduce discharge deterioration, discharge at low rate and discharge with narrow DOD are recommended" as a usage condition when battery pack 41 is secondarily used for a power storage system for the backup power source (S64 g).

For example, when the breakdown ratio of "the storage deterioration amount soh_s" : "the charge deterioration amount soh_c" : "the discharge deterioration amount soh_d" of battery pack 41 is "large" : "small" : "small" (S64h), reuse determination unit 115 determines that the secondary use destination is a power storage system for frequency regulation (FR) for stabilizing the power system (S64i). Comment generation unit 117 generates a comment such as "To reduce storage deterioration, storing in a low SOC state is recommended" as a usage condition when battery pack 41 is secondarily used in a power storage system for power frequency regulation (S64j).

Battery analysis system 1 continues to acquire the use history data of battery pack 41 also after the secondary use start of battery pack 41. Reuse determination unit 115 compares the sum of the storage deterioration amount soh_s, the charge deterioration amount soh_c, and the discharge deterioration amount soh_d of battery pack 41 being secondarily used with the recycle threshold (S70). When the sum of the three deterioration amounts is larger than or equal to the recycle threshold (Y in S70), reuse determination unit 115 determines to end the secondary use of battery pack 41, disassemble battery pack 41 and the internal battery module, and recycle the material (S71). As a determination condition for recycling, the SOH of battery pack 41 being secondarily used may be compared with the recycle threshold.

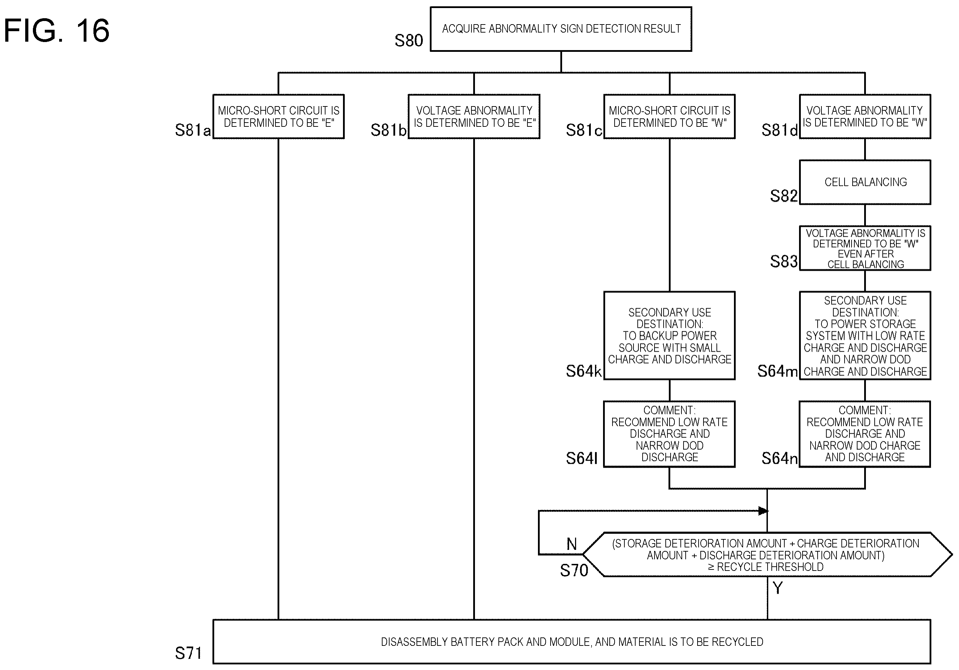

Fig. 16 is a flowchart for describing Specific Example 2 of the processing of determining the secondary use destination. Reuse determination unit 115 holds a secondary use destination determination table in which the secondary use destination is associated with the case in which the determination result of each abnormality sign detection item set in advance is the warning "W". Reuse determination unit 115 acquires an abnormality sign detection result of battery pack 41 made by abnormality sign detector 116 (S80).

For example, when the determination result of the micro-short circuit detection is abnormality "E " (S81a), there is a high risk with continuous use of battery pack 41. Therefore, reuse determination unit 115 determines to end the primary use of battery pack 41, disassemble battery pack 41 and the internal battery module, and recycle the material (S71).

For example, also when the determination result of the voltage abnormality detection is abnormality "E" (S81b), there is a high risk with continuous use of battery pack 41. Therefore, reuse determination unit 115 determines to end the primary use of battery pack 41, disassemble battery pack 41 and the internal battery module, and recycle the material (S71).

For example, when the determination result of the micro-short circuit detection is the warning "W" (S8lc), if the primary use is continued as it is, the risk of proceeding to the abnormality "E" is high. Reuse determination unit 115 determines that the secondary use destination is the power storage system for the backup power source with a low frequency of charging and discharging (S64k). Comment generation unit 117 generates a comment such as "To reduce discharge deterioration, discharge at low rate and discharge with narrow DOD are recommended" as a usage condition when battery pack 41 is secondarily used for a power storage system for the backup power source (S641).

For example, when the determination result of the voltage abnormality detection is the warning "W" (S8ld), reuse determination unit 115 recommends cell balancing of battery pack 41 (S82). When the determination result is the warning "W" even in the voltage abnormality detection after the cell balancing (S83), there is a high risk of proceeding to the abnormality "E". Reuse determination unit 115 determines that the secondary use destination is the power storage system of a usage mode with a low rate and a low frequency of charging and discharging (S64m). The secondary use destination may be determined when the determination result of the voltage abnormality detection is the warning "W" at a plurality of consecutive times after the cell balancing. Comment generation unit 117 generates a comment such as "To reduce charge deterioration and discharge deterioration, it is recommended to charge and discharge at a low rate and to charge and discharge at a narrow DOD" as the usage condition when battery pack 41 is secondarily used for the power storage system of the usage mode (S64n).

Battery analysis system 1 continues to acquire the use history data of battery pack 41 also after the secondary use start of battery pack 41. Reuse determination unit 115 compares the sum of the storage deterioration amount soh_s, the charge deterioration amount soh_c, and the discharge deterioration amount soh_d of battery pack 41 with the recycle threshold (S70). When the sum of the three deterioration amounts is larger than or equal to the recycle threshold (Y in S70), reuse determination unit 115 determines to end the secondary use of battery pack 41, disassemble battery pack 41 and the internal battery module, and recycle the material (S71).

As described above, according to the present exemplary embodiment, it is possible to determine an appropriate secondary use destination of battery pack 41 by considering the internal state of battery pack 41. For example, in the case of battery pack 41 in which the discharge deterioration progresses and the charge deterioration and the storage deterioration do not relatively progress, the secondary use period of battery pack 41 can be lengthened by determining secondary use destination to be the power storage system for the backup power source in which the frequency of discharge is low. When an appropriate secondary use destination is determined for battery pack 41 in this manner, the lifetime use value of battery pack 41 can be maximized.

The present disclosure is described above with the exemplary embodiments. It is to be understood by the person of ordinary skill in the art that the exemplary embodiment is merely an example, that various modifications can be made by combining each component and each processing process of the exemplary embodiment, and that such modifications are also within the scope of the present disclosure.

The battery analysis method according to the above exemplary embodiment determines the end time of the primary use and the secondary use destination of battery pack 41. In this respect, the battery analysis method according to the above exemplary embodiment can also be applied to the processing of determining the end time of the secondary use and the tertiary use destination of battery pack 41.

The functions executed by battery analysis system 1 described above may be incorporated in management unit 42 of power supply system 40 in electric vehicle 3. In this case, a large-capacity memory is required, but data transmission can be made unnecessary.

In the exemplary embodiment described above, a four-wheeled electric automobile is assumed as electric vehicle 3. In this respect, electric vehicle 3 may be an electric motorcycle (electric scooter), an electric bicycle, or an electric kick scooter. Examples of the electric automobile include not only full-standard electric vehicles but also low-speed electric automobiles such as golf carts and land cars. The targets to be equipped with battery pack 41 are not limited to electric vehicle 3. The targets equipped with battery pack 41 also include an electric ship, a railway vehicle, a construction machine, an electric moving body such as a multi-copter (drone), a stationary power storage system that is charged and discharged with a high load, and medical equipment.

The exemplary embodiment may be defined by the following items.

[Item 1]

Battery analysis system (1) including:

data acquisition unit (111) configured to acquire use history data of secondary battery (41) and battery information for identifying a type of secondary battery (41);
deterioration characteristic search unit (112) configured to search deterioration characteristic database (1b) based on the battery information to identify deterioration characteristic information including a storage deterioration characteristic, a charge deterioration characteristic, and a discharge deterioration characteristic of secondary battery (41);
internal deterioration state analysis unit (113) configured to estimate a storage deterioration amount, a charge deterioration amount, and a discharge deterioration amount of secondary battery (41) based on the deterioration characteristic information and use the history data acquired by the data acquisition unit (111); and
reuse determination unit (115) configured to determine a secondary use destination after an end of primary use of secondary battery (41) based on a breakdown of a storage deterioration amount, a charge deterioration amount, and a discharge deterioration amount of secondary battery (41).

This makes it possible to determine an appropriate secondary use destination of battery pack (41).

[Item 2]

Battery analysis system (1) according to Item 1, further including comment generation unit (117) configured to generate a comment regarding a usage condition of secondary battery (41) at a secondary use destination determined by the reuse determination unit (115), when the reuse determination unit (115) determines the secondary use destination.

This makes it possible to provide an appropriate comment for preventing deterioration to the administrator of the secondary use destination of battery pack (41).

[Item 3]

Battery analysis system (1) according to Item 1, further including State Of Health (SOH) estimation unit (114) configured to estimate a current SOH of secondary battery (41) based on the storage deterioration amount, the charge deterioration amount, and the discharge deterioration amount each estimated by the internal deterioration state analysis unit (113),
wherein reuse determination unit (115) determines the secondary use destination when the current SOH is less than or equal to an SOH threshold.

This makes it possible to determine an appropriate end time of the primary use of battery pack (41) and proceed to the determination of the secondary use destination.

[Item 4]

Battery analysis system (1) according to Item 3, wherein

SOH estimation unit (114) predicts a future SOH of secondary battery (41) based on the current SOH and a predicted charge and discharge pattern of secondary battery (41), and
reuse determination unit (115) predicts a time at which the SOH of the secondary battery (41) becomes less than or equal to the SOH threshold based on a predicted future SOH, and determines the secondary use destination at the time.

This makes it possible to determine an appropriate end time of the primary use of battery pack (41) and proceed to the determination of the secondary use destination.

[Item 5]

Battery analysis system (1) according to Item 1, further including abnormally sign detector (116) configured to detect an abnormality sign of secondary battery (41) based on the use history data acquired by the data acquisition unit (111),
wherein when a result of detecting the abnormality sign is a warning level between a normal state and an abnormal state, reuse determination unit (115) determines the secondary use destination regardless of a SOH of secondary battery (41).

This makes it possible to end the primary use and determine an appropriate secondary use destination in accordance with the result of the abnormality sign detection even during the primary use still having a high SOH.

[Item 6]

Battery analysis method including:

a step of acquiring use history data of secondary battery (41) and battery information for identifying a type of secondary battery (41);
a step of searching deterioration characteristic database (1b) based on the battery information and of identifying deterioration characteristic information including a storage deterioration characteristic, a charge deterioration characteristic, and a discharge deterioration characteristic of secondary battery (41);
a step of estimating a storage deterioration amount, a charge deterioration amount, and a discharge deterioration amount of secondary battery (41) based on identified deterioration characteristic information and use history data of secondary battery (41); and

a step of determining a secondary use destination after an end of primary use of secondary battery (41) based on a breakdown of the storage deterioration amount, the charge deterioration amount, and the discharge deterioration amount of secondary battery (41).

This makes it possible to determine an appropriate secondary use destination of battery pack (41).

[Item 7]

Battery analysis method including causing a computer to execute:

processing of acquiring use history data of secondary battery (41) and battery information for identifying a type of secondary battery (41);
processing of searching deterioration characteristic database (1b) based on the battery information and of identifying deterioration characteristic information including a storage deterioration characteristic, a charge deterioration characteristic, and a discharge deterioration characteristic of secondary battery (41);
processing of estimating a storage deterioration amount, a charge deterioration amount, and a discharge deterioration amount of secondary battery (41) based on identified deterioration characteristic information and use history data of secondary battery (41); and
processing of determining a secondary use destination after an end of primary use of secondary battery (41) based on a breakdown of the storage deterioration amount, the charge deterioration amount, and the discharge deterioration amount of secondary battery (41).

This makes it possible to determine an appropriate secondary use destination of battery pack (41).

## REFERENCE MARKS IN THE DRAWINGS

| | |
|---|---|
| 1 | battery analysis system |
| 1a | arithmetic server |
| 1b | deterioration characteristic holding server |
| 2 | operation management terminal apparatus |
| 3 | electric vehicle |
| 4 | data server |
| 5 | network |
| 11 | processor |
| 111 | data acquisition unit |
| 112 | deterioration characteristic search unit |
| 113 | internal deterioration state analysis unit |
| 114 | SOH estimation unit |
| 115 | reuse determination unit |
| 116 | abnormality sign detector |
| 117 | comment generation unit |
| 118 | notification unit |
| 12 | storage unit |
| 121 | battery deterioration characteristic holder |
| 13 | communication unit |
| 30 | vehicle controller |
| 31f | front wheel |
| 31r | rear wheel |
| 32f | front wheel axle |
| 32r | rear wheel axle |
| 33 | transmission |
| 34 | motor |
| 35 | inverter |
| 36 | vehicle speed sensor |
| 37 | wireless communication unit |
| 37a | antenna |

40 power supply system
41 battery pack
42 management unit

**Claims**

1. A battery analysis system comprising:

   a data acquisition unit configured to acquire use history data of a secondary battery and battery information for identifying a type of the secondary battery;
   a deterioration characteristic search unit configured to search a deterioration characteristic database based on the battery information to identify deterioration characteristic information including a storage deterioration characteristic, a charge deterioration characteristic, and a discharge deterioration characteristic of the secondary battery;
   an internal deterioration state analysis unit configured to estimate a storage deterioration amount, a charge deterioration amount, and a discharge deterioration amount of the secondary battery based on the deterioration characteristic information identified by the deterioration characteristic search unit and the use history data acquired by the data acquisition unit; and
   a reuse determination unit configured to determine a secondary use destination after an end of primary use of the secondary battery, based on a breakdown of the storage deterioration amount, the charge deterioration amount, and the discharge deterioration amount each estimated by the internal deterioration state analysis unit.

2. The battery analysis system according to Claim 1, further comprising
   a comment generation unit configured to generate a comment regarding a usage condition of the secondary battery at the secondary use destination determined by the reuse determination unit, when the reuse determination unit determines the secondary use destination.

3. The battery analysis system according to Claim 1, further comprising

   a State Of Health (SOH) estimation unit configured to estimate a current SOH of the secondary battery based on the storage deterioration amount, the charge deterioration amount, and the discharge deterioration amount each estimated by the internal deterioration state analysis unit,
   wherein the reuse determination unit determines the secondary use destination when the current SOH is less than or equal to an SOH threshold.

4. The battery analysis system according to Claim 3, wherein

   the SOH estimation unit predicts a future SOH of the secondary battery based on the current SOH and a predicted charge and discharge pattern of the secondary battery, and
   the reuse determination unit predicts a time at which a SOH of the secondary battery becomes less than or equal to the SOH threshold based on the predicted future SOH, and determines the secondary use destination at the time.

5. The battery analysis system according to Claim 1, further comprising

   an abnormality sign detector configured to detect an abnormally sign of the secondary battery based on the use history data acquired by the data acquisition unit,
   wherein when a result of detecting the abnormality sign is a warning level between a normal state and an abnormal state, the reuse determination unit determines the secondary use destination regardless of a SOH of the secondary battery.

6. A battery analysis method comprising:

   a step of acquiring use history data of a secondary battery and battery information for identifying a type of the secondary battery;
   a step of searching a deterioration characteristic database based on the battery information and of identifying deterioration characteristic information including a storage deterioration characteristic, a charge deterioration characteristic, and a discharge deterioration characteristic of the secondary battery;

a step of estimating a storage deterioration amount, a charge deterioration amount, and a discharge deterioration amount of the secondary battery based on identified deterioration characteristic information and use history data of the secondary battery; and

a step of determining a secondary use destination after an end of primary use of the secondary battery based on a breakdown of the storage deterioration amount, the charge deterioration amount, and the discharge deterioration amount of the secondary battery.

7. A battery analysis method comprising causing a computer to execute:

processing of acquiring use history data of a secondary battery and battery information for identifying a type of the secondary battery;

processing of searching a deterioration characteristic database based on the battery information and of identifying deterioration characteristic information including a storage deterioration characteristic, a charge deterioration characteristic, and a discharge deterioration characteristic of the secondary battery;

processing of estimating a storage deterioration amount, a charge deterioration amount, and a discharge deterioration amount of the secondary battery based on identified deterioration characteristic information and use the history data of the secondary battery; and

processing of determining a secondary use destination after an end of primary use of the secondary battery based on a breakdown of a storage deterioration amount, a charge deterioration amount, and a discharge deterioration amount of the secondary battery.

8. A transitory storage medium comprising a battery analysis program recorded on the transitory storage medium, the battery analysis program being executed by the computer that executes the battery analysis method according to Claim 7.

FIG. 1

# FIG. 2

ELECTRIC VEHICLE  3

ELECTRIC VEHICLE  3

ELECTRIC VEHICLE  3

OPERATION MANAGEMENT TERMINAL APPARATUS  2

5

ARITHMETIC SERVER  1a

DETERIORATION CHARACTERISTIC HOLDING SERVER  1b

BATTERY ANALYSIS SYSTEM  1

DATA SERVER  4

# FIG. 3

```
                                    5                                          1
                                    |
                                   13
                          ┌──────────────────┐
                          │  COMMUNICATION   │
                          │       UNIT        │
                          └──────────────────┘

                                                                       11

        111                      112                      113
  ┌──────────────┐      ┌──────────────────┐      ┌──────────────────────┐
  │DATA ACQUISITION│    │  DETERIORATION   │      │      INTERNAL        │
  │     UNIT      │      │  CHARACTERISTIC   │      │ DETERIORATION STATE  │
  └──────────────┘      │   SEARCH UNIT     │      │   ANALYSIS UNIT      │
        114              └──────────────────┘      └──────────────────────┘
                               115                       116
  ┌──────────────┐      ┌──────────────────┐      ┌──────────────────────┐
  │     SOH      │      │     REUSE        │      │  ABNORMALITY SIGN    │
  │ ESTIMATION UNIT│    │ DETERMINATION UNIT│      │     DETECTOR         │
  └──────────────┘      └──────────────────┘      └──────────────────────┘
        117                    118
  ┌──────────────┐      ┌──────────────────┐
  │   COMMENT    │      │ NOTIFICATION UNIT │
  │GENERATION UNIT│      └──────────────────┘
  └──────────────┘

                          PROCESSOR

                                                          12
                               121
                    ┌─────────────────────────┐
                    │  BATTERY DETERIORATION   │
                    │ CHARACTERISTIC HOLDER    │
                    │                          │
                    │      STORAGE UNIT        │
                    └─────────────────────────┘

                 BATTERY ANALYSIS SYSTEM
```

# FIG. 4

# FIG. 5A

# FIG. 5B

# FIG. 6

START

S50 $SP = 100 - [abs(a-d) + abs(b-e) + abs(c-f)]$

S51 $SN = 100 - [abs(g-i) + abs(h-j)]$

S52 $SE = 100 - [abs(k-m)/(k+m) + abs(l-n)/(l+n)]$

S53 $S = w1*SP + w2*SN + w3*SE$

S54 IDENTIFY BATTERY WITH MAXIMUM S

S55 ACQUIRE DETERIORATION CHARACTERISTIC INFORMATION OF IDENTIFIED BATTERY

END

# FIG. 7

START

S10 — IS UPDATE CONDITION OF soh_s SATISFIED? — N

Y

S11 — ESTIMATE Δsoh_s

S16 — $\Delta soh\_s' = Fs3(\Delta soh\_s, soh)$

S17 — $soh\_s = soh\_s + \Delta soh\_s'$

S18 — $soh = 100 - (soh\_s + soh\_c + soh\_d)$

S20 — IS UPDATE CONDITION OF soh_c SATISFIED? — N

Y

S21 — ESTIMATE Δsoh_c

S26 — $\Delta soh\_c' = Fc3(\Delta soh\_c, DOD)$

S27 — $soh\_c = soh\_c + \Delta soh\_c'$

S28 — $soh = 100 - (soh\_s + soh\_c + soh\_d)$

S30 — IS UPDATE CONDITION OF soh_d SATISFIED? — N

Y

S31 — ESTIMATE Δsoh_d

S36 — $\Delta soh\_d' = Fd3(\Delta soh\_d, DOD)$

S37 — $soh\_d = soh\_d + \Delta soh\_d'$

S38 — $soh = 100 - (soh\_s + soh\_c + soh\_d)$

S40 — N — HAS DETERIORATION ESTIMATION PROCESSING STOPPED?

Y

END

# FIG. 8

$\Delta$ soh_s

S12 | ACQUIRE soh_s [%], soc [%], temp [°C], $\Delta$time [h]

S13 | Ks = STORAGE DETERIORATION CHARACTERISTIC (soc, temp)

S14 | totaltime $=$ Fs1 (soh_s,Ks,ps)

S15 | $\Delta$ soh_s $=$ Fs2 (Ks,totaltime, $\Delta$ time)

Return

# FIG. 9

$\Delta$ soh_c

S22　ACQUIRE soh_c [%], soc [%], rate [C], temp [°C], $\Delta$cap_c [Ah]

S23　Kc = CHARGE DETERIORATION CHARACTERISTIC (soc, rate, temp)

S24　$chgcap = Fc1(soh\_c, Kc, pc)$

S25　$\Delta soh\_c = Fc2(Kc, chgcap, \Delta cap\_c)$

Return

# FIG. 10

```
        ┌──────────────┐
        │   Δsoh_d     │
        └──────┬───────┘
               │
   ┌───────────┴────────────────────────────────┐
S32│ ACQUIRE soh_d [%], soc [%], rate [C], temp [°C],│
   │              Δcap_d [Ah]                     │
   └───────────┬────────────────────────────────┘
               │
   ┌───────────┴────────────────────────────────┐
S33│ Kd = DISCHARGE DETERIORATION                 │
   │     CHARACTERISTIC (soc, rate, temp)         │
   └───────────┬────────────────────────────────┘
               │
   ┌───────────┴────────────────────────────────┐
S34│        discap = Fd1 (soh_d,Kd,pd)            │
   └───────────┬────────────────────────────────┘
               │
   ┌───────────┴────────────────────────────────┐
S35│     Δsoh_d = Fd2 (Kd,discap, Δcap_d)        │
   └───────────┬────────────────────────────────┘
               │
        ┌──────┴───────┐
        │   Return     │
        └──────────────┘
```

## FIG. 11

SOH[%]

ELAPSED DAYS [day]

## FIG. 12

(100−SOH)[%]

soh_s

soh_d
soh_c

ELAPSED DAYS [day]

# FIG. 13

```
                    ┌──────────────┐
                    │    START     │
                    └──────┬───────┘
                           │
        ┌──────────────────┤
        │                  ▼
   N  ◄─┤      IS IT TIME
        │   TO EXECUTE REUSE DETERMINATION
   S60      PROCESSING?
                           │ Y
                           ▼
   S61   ┌──────────────────────────────────────────┐
         │         ACQUIRE ANALYSIS RESULT OF        │
         │  INTERNAL DETERIORATION STATE OF BATTERY  │
         └──────────────────────────────────────────┘
                           │
                           ▼
   S62   ┌──────────────────────────────────────────┐
         │       DETERMINE END TIME OF PRIMARY USE   │
         └──────────────────────────────────────────┘
                           │
                           ▼
   S63        HAS END TIME OF PRIMARY USE ARRIVED?  ─── N
                           │ Y
                           ▼
   S64   ┌──────────────────────────────────────────┐
         │      DETERMINE SECONDARY USE DESTINATION  │
         └──────────────────────────────────────────┘
                           │
                           ▼
   S65   ┌──────────────────────────────────────────┐
         │      OUTPUT REUSE DETERMINATION RESULT    │
         └──────────────────────────────────────────┘
                           │
                           ▼
                    ┌──────────────┐
                    │     END      │
                    └──────────────┘
```

# FIG. 14

START

S61a ACQUIRE CURRENT SOH AND PREDICTED SOH

S62a CURRENT SOH ≤ SOH THRESHOLD?

Y

N

S62b PREDICTED SOH ≤ SOH THRESHOLD?

N

Y

S62c PREDICT END TIME OF PRIMARY USE

S62d PERIOD UNTIL END TIME OF PRIMARY USE ≤ PERIOD THRESHOLD?

N

Y

S64 DETERMINE SECONDARY USE DESTINATION

S65 OUTPUT REUSE DETERMINATION RESULT

END

FIG. 15

S64a — ACQUIRE STORAGE DETERIORATION AMOUNT, CHARGE DETERIORATION AMOUNT, AND DISCHARGE DETERIORATION AMOUNT

S64b — CHARGE DETERIORATION "LARGE" DISCHARGE DETERIORATION "SMALL"

S64e — DISCHARGE DETERIORATION "LARGE" CHARGE DETERIORATION "SMALL"

S64h — STORAGE DETERIORATION "LARGE" CHARGE DETERIORATION AND DISCHARGE DETERIORATION "SMALL"

• • •

S64c — SECONDARY USE DESTINATION: TO LOW-SPEED EV

S64f — SECONDARY USE DESTINATION: TO BACKUP POWER SOURCE

S64i — SECONDARY USE DESTINATION: TO POWER FREQUENCY ADJUSTMENT POWER SOURCE

• • •

S64d — COMMENT: RECOMMENDED LOW RATE CHARGE

S64g — COMMENT: RECOMMEND LOW RATE DISCHARGE AND NARROW DOD DISCHARGE

S64j — COMMENT: RECOMMEND LOW SOC STORAGE

• • •

S70 — N / (STORAGE DETERIORATION AMOUNT + CHARGE DETERIORATION AMOUNT + DISCHARGE DETERIORATION AMOUNT) ≥ RECYCLE THRESHOLD

Y

S71 — DISASSEMBLY BATTERY PACK AND MODULE, AND MATERIAL IS TO BE RECYCLED

EP 4 693 593 A1

# FIG. 16

S80 — ACQUIRE ABNORMALITY SIGN DETECTION RESULT

S81a — MICRO-SHORT CIRCUIT IS DETERMINED TO BE "E"

S81b — VOLTAGE ABNORMALITY IS DETERMINED TO BE "E"

S81c — MICRO-SHORT CIRCUIT IS DETERMINED TO BE "W"

S81d — VOLTAGE ABNORMALITY IS DETERMINED TO BE "W"

S82 — CELL BALANCING

S83 — VOLTAGE ABNORMALITY IS DETERMINED TO BE "W" EVEN AFTER CELL BALANCING

S64k — SECONDARY USE DESTINATION: TO BACKUP POWER SOURCE WITH SMALL CHARGE AND DISCHARGE

S64m — SECONDARY USE DESTINATION: TO POWER STORAGE SYSTEM WITH LOW RATE CHARGE AND DISCHARGE AND NARROW DOD CHARGE AND DISCHARGE

S64l — COMMENT: RECOMMEND LOW RATE DISCHARGE AND NARROW DOD DISCHARGE

S64n — COMMENT: RECOMMEND LOW RATE DISCHARGE AND NARROW DOD CHARGE AND DISCHARGE

S70 — N / (STORAGE DETERIORATION AMOUNT + CHARGE DETERIORATION AMOUNT + DISCHARGE DETERIORATION AMOUNT) ≥ RECYCLE THRESHOLD — Y

S71 — DISASSEMBLY BATTERY PACK AND MODULE, AND MATERIAL IS TO BE RECYCLED

## INTERNATIONAL SEARCH REPORT

| International application No. |
| --- |
| **PCT/JP2024/004386** |

| | |
| --- | --- |
| **A.** | **CLASSIFICATION OF SUBJECT MATTER** |

*H01M 10/42*(2006.01)i; *G01R 31/378*(2019.01)i; *G01R 31/392*(2019.01)i; *H01M 10/48*(2006.01)i; *H02J 7/00*(2006.01)i
FI:    H01M10/42 P; G01R31/378; G01R31/392; H01M10/48 P; H02J7/00 P; H02J7/00 Y

According to International Patent Classification (IPC) or to both national classification and IPC

| | |
| --- | --- |
| **B.** | **FIELDS SEARCHED** |

Minimum documentation searched (classification system followed by classification symbols)
    H01M10/42; G01R31/378; G01R31/392; H01M10/48; H02J7/00

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

| | |
| --- | --- |
| **C.** | **DOCUMENTS CONSIDERED TO BE RELEVANT** |

| Category* | Citation of document, with indication, where appropriate, of the relevant passages | Relevant to claim No. |
| --- | --- | --- |
| A | WO 2015/012144 A1 (NISSAN MOTOR CO., LTD.) 29 January 2015 (2015-01-29) entire text, all drawings | 1-8 |
| A | WO 2013/084481 A1 (PANASONIC CORPORATION) 13 June 2013 (2013-06-13) entire text, all drawings | 1-8 |
| A | JP 2022-022630 A (HONDA MOTOR CO., LTD.) 07 February 2022 (2022-02-07) entire text, all drawings | 1-8 |
| A | WO 2016/194082 A1 (NISSAN MOTOR CO., LTD.) 08 December 2016 (2016-12-08) entire text, all drawings | 1-8 |

☐ Further documents are listed in the continuation of Box C.        ☑ See patent family annex.

| | |
| --- | --- |
| *    Special categories of cited documents:<br>"A"   document defining the general state of the art which is not considered to be of particular relevance<br>"D"   document cited by the applicant in the international application<br>"E"   earlier application or patent but published on or after the international filing date<br>"L"   document which may throw doubts on priority claim(s) or which is cited to establish the publication date of another citation or other special reason (as specified)<br>"O"   document referring to an oral disclosure, use, exhibition or other means<br>"P"   document published prior to the international filing date but later than the priority date claimed | "T"   later document published after the international filing date or priority date and not in conflict with the application but cited to understand the principle or theory underlying the invention<br>"X"   document of particular relevance; the claimed invention cannot be considered novel or cannot be considered to involve an inventive step when the document is taken alone<br>"Y"   document of particular relevance; the claimed invention cannot be considered to involve an inventive step when the document is combined with one or more other such documents, such combination being obvious to a person skilled in the art<br>"&"   document member of the same patent family |

| Date of the actual completion of the international search | Date of mailing of the international search report |
| --- | --- |
| **16 April 2024** | **23 April 2024** |

| Name and mailing address of the ISA/JP | Authorized officer |
| --- | --- |
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (July 2022)

## INTERNATIONAL SEARCH REPORT
### Information on patent family members

International application No.

**PCT/JP2024/004386**

| Patent document cited in search report | | | Publication date (day/month/year) | Patent family member(s) | | | Publication date (day/month/year) |
|---|---|---|---|---|---|---|---|
| WO | 2015/012144 | A1 | 29 January 2015 | US | 2016/0162849 | A1 | |
| | | | | entire text, all drawings | | | |
| | | | | EP | 3026751 | A1 | |
| | | | | CN | 105706290 | A | |
| WO | 2013/084481 | A1 | 13 June 2013 | US | 2014/0320144 | A1 | |
| | | | | entire text, all drawings | | | |
| | | | | EP | 2790262 | A1 | |
| | | | | CN | 104025367 | A | |
| JP | 2022-022630 | A | 07 February 2022 | (Family: none) | | | |
| WO | 2016/194082 | A1 | 08 December 2016 | US | 2018/0156873 | A1 | |
| | | | | entire text, all drawings | | | |
| | | | | EP | 3306735 | A1 | |
| | | | | CN | 107615562 | A | |

Form PCT/ISA/210 (patent family annex) (July 2022)

**REFERENCES CITED IN THE DESCRIPTION**

**Patent documents cited in the description**

- WO 21152826 A